# EUROPEAN PATENT SPECIFICATION

(11) **EP 1 973 151 B1**
(45) Date of publication and mention of the grant of the patent: **15.07.2015**
(21) Application number: 08003673.4
(22) Date of filing: 28.02.2008
(51) Int. Cl.: H01L 21/265, H01L 21/322

(54) **Soi wafer and manufacturing method thereof**
SOI-Wafer und Verfahren zu seiner Herstellung
Tranche SOI et son procédé de fabrication

(30) Priority: 20.03.2007 JP 2007071800
(43) Date of publication of application: 24.09.2008
(73) Proprietor: SUMCO CORPORATION, Minato-ku, Tokyo (JP)
(72) Inventor: Ono, Toshiaki, Tokyo (JP); Hourai, Masataka, Tokyo (JP)
(74) Representative: Beckmann, Claus

(56) References cited:
- EP-A- 1 087 041
- US-A1- 2005 202 658
- US-A1- 2006 121 692

## Description

### TECHNICAL FIELD

The present invention relates to an SOI (Silicon on Insulator) wafer suitable for a process of manufacturing a semiconductor device in which an extremely-short thermal treatment is conducted for no more than 0.1 seconds at a maximum temperature of 1200°C or more, and manufacturing method thereof.
This application claims priority from Japanese Patent Application No. 2007-071800 filed on March 20, 2007.

### BACKGROUND ART

Since devices have been highly integrated and consumption of electric power needed to work such devices has been decreased, an extremely-short thermal treatment no more than 0.1 seconds at a maximum temperature of 1200°C or more, such as laser annealing, has been applied for a process of manufacturing a device. Particularly, in the case that only one side of an SOI wafer is heated in a laser annealing furnace, not only an active layer in the SOI wafer, but also a part of an insulated oxide film layer and a support layer are sometimes heated in spite of the treatment being conducted for an extremely short time.

It has been found that, if the support layer is heated even for such a short time, a large amount of stress is generated near an interface between the support layer and the insulated oxide film layer, because oxygen precipitates near the interface obstruct a heat conduction, and thus a slip dislocation is generated at a high density, thereby causing plastic deformation at the region just below the insulated oxide film layer.

Such plastic deformation causes a defocus when the exposure is conducted in the process of manufacturing a device, and deteriorates the yield ratio.

Patent Document
Japanese Unexamined Patent Application, First Publication No. 2006-237042

EP1087041A1 relates to an SOI wafer and its manufacturing method reducing generation of slip dislocations by controlling interstitial oxygen concentration and bulk defect density.

### DISCLOSURE OF THE INVENTION

### PROBLEMS TO BE SOLVED BY THE INVENTION

The present invention takes the above circumstances into consideration, with an object of providing an SOI wafer which does not generate slip dislocation, even if laser annealing is conducted at a maximum temperature of 1200°C or more for no more than 0.1 seconds.

### MEANS FOR SOLVING THE PROBLEMS

The present invention is an SOI wafer as defined in claim 1 and its manufacturing method as defined in claim 3.

### EFFECTS OF THE INVENTION

In the present invention, since the light-scattering defect density measured by a 90° light-scattering method at the depth region of 260 µm toward the support layer side from the interface between the insulated oxide film layer and the support layer is no more than 2×10⁸/cm³, slip dislocation is not generated even if laser annealing is conducted at a maximum temperature of 1200°C or more for no more than 0.1 seconds.

### BRIEF DESCRIPTION OF THE DRAWINGS

FIG. 1 is a drawing showing a pattern (pattern 1) of a heat treatment in the Examples.
FIG. 2 is a drawing showing a pattern (pattern 2) of a heat treatment in the Examples.
FIG. 3 is a drawing showing a pattern (pattern 3) of a heat treatment in the Examples.
FIG. 4 is a drawing showing a pattern (pattern 4) of a heat treatment in the Examples.
FIG. 5 is a sectional view showing a structure of an SOI wafer.

### BEST MODE FOR CARRYING OUT THE INVENTION

In the following examples, it is confirmed that slip dislocation is not generated even if laser annealing is conducted at a maximum temperature of 1200°C for no more than 0.1 seconds, when the light-scattering defect density measured by a 90° light-scattering method at the depth region of 260 µm toward the support layer side from the interface between the insulated oxide film layer and the support layer is no more than 2×10⁸/cm³.

### EXAMPLES

### Example 1

A silicon wafer (oxygen concentration of 11.5×10¹⁷ to 13.6×10¹⁷ atoms/cm³ (Old-ASTM)) sliced from a monocrystaline silicon ingot of 200 mm in diameter was heated up to 650°C, then oxygen ions with the acceleration energy of 200 keV and the dose amount of 5×10¹⁷/cm² were implanted into the wafer. As a result, the oxygen ions reacted with the monocrystaline silicon wafer, thereby forming an embedded SiO₂ layer (insulated oxide film layer) inside the monocrystaline silicon wafer. On the embedded SiO₂ layer, that is, on the surface of the monocrystaline silicon wafer, a residual silicon layer with the implantation damage was formed.

Subsequently, the monocrystaline silicon wafer was heated at 1325°C for 8 hours in a mixed atmosphere of Ar and O₂. By performing the high-temperature thermal treatment, precipitates other than the embedded SiO₂ were removed from the monocrystaline silicon wafer, and a monocrystaline silicon layer (an active layer) in which silicon atoms were rearranged was formed on the surface of the monocrystaline silicon wafer. The thickness of the active layer and the embedded SiO₂ layer were measured by using a transmission microscope, and the result was that the thickness of the active layer was 200 nm, and the thickness of the embedded SiO₂ layer was 125 nm.

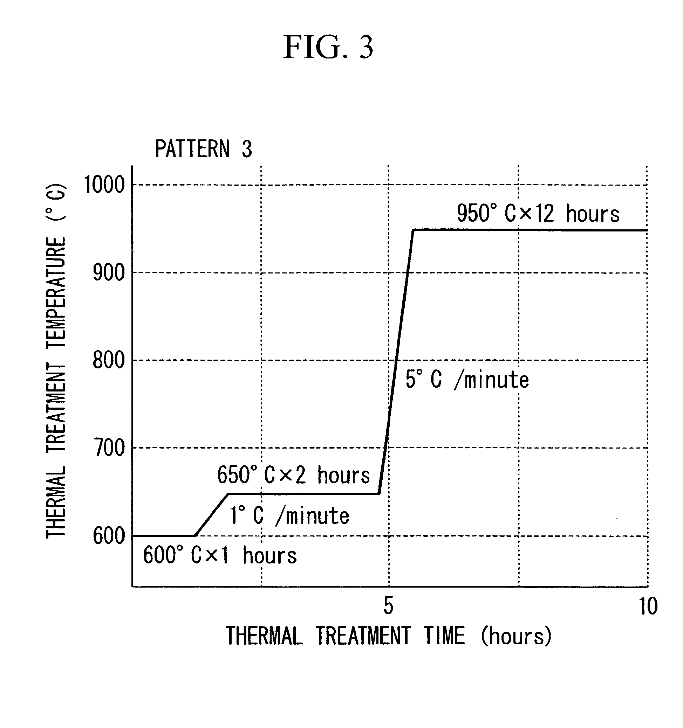

The SOI wafer obtained above was subjected to a thermal treatment of pattern 3 shown in FIG. 3. The thermal treatment included the steps of: leaving the SOI wafer at 600°C for 1 hour; heating it to 650°C at a heating rate of 1°C/minute (50 minutes); leaving it at 650°C for 2 hours; heating it to 950°C at a heating rate of 5°C/minute (60 minutes); and leaving it at 950°C for 12 hours.

The defect density near the interface between the insulated oxide film layer and the support layer induced by the thermal treatment was evaluated by a 90° light-scattering method, using MO-441 (manufactured by Mitsui Mining & Smelting Co. Ltd.). The measurement of the light-scattering defect (light-scattering body) in the 90° light-scattering method was conducted by irradiating a light with a wavelength of 1.06 µm (near-infrared) and the output power of 100 mW from the upper surface of the silicon wafer, thereby detecting the 90° scattered light which was detected from a cleavage surface of the wafer. The 90° scattered light was attenuated by passing through a filter.

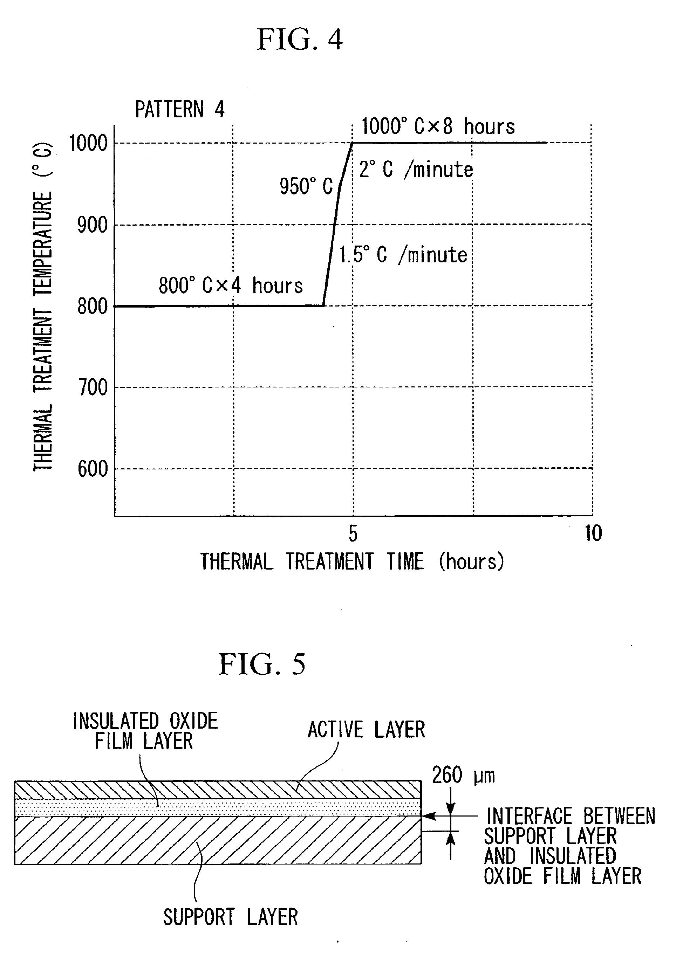

The measured region was up to the depth of 260 µm from the interface between the insulated oxide film layer and the support layer, as shown in FIG. 5. The light-scattering defect density was measured at the 10 points determined randomly in the radial direction of the wafer, wherein 2 mm in the radial direction of the wafer was referred to as a point.

The result is shown in Table 1. The light-scattering defect density was 1.1 × 10⁸/cm³.

Subsequently, the SOI wafer of Example 1 was subjected to an extremely-short thermal treatment (laser annealing) which was performed in a process of manufacturing a device, in a laser spike annealing furnace in a condition of a maximum temperature of 1200°C. Then, it was checked using an X-ray topography method whether there was slip dislocation migrated to the surface of the wafer or not. As a result, the slip dislocation was not observed, as shown in Table 1.

### Example 2

A silicon wafer (oxygen concentration of 11.5×10¹⁷ to 13.6×10¹⁷ atoms/cm³ (Old-ASTM)) sliced from a monocrystaline silicon ingot of 200 nm in diameter, which is the same as that of Example 1, was heated to 650°C, and then oxygen ions with the acceleration energy of 200 keV and the dose amount of 5×10¹⁷/cm² were implanted into the silicon wafer.

Subsequently, similarly to Example 1, the monocrystaline silicon wafer was thermally treated at 1325°C for 8 hours in a mixed atmosphere of Ar and O₂, thereby producing an SOI wafer. The thickness of the active layer and the embedded SiO₂ layer formed by the above thermal treatment were checked using a transmission microscope. As a result, the thickness of the active layer was 200 nm, and the thickness of the embedded SiO₂ layer was 125 nm.

The SOI wafer obtained in this way was subjected to a thermal treatment of pattern 3 shown in FIG. 3, and then defect density induced by the thermal treatment near the interface between the support layer and the insulated oxide film layer of the SOI wafer after the thermal treatment was evaluated by a 90° light-scattering method, using MO-441 (manufactured by Mitsui Mining & Smelting Co. Ltd.). As shown in Table 1, the light-scattering defect density was 1.9×10⁸/cm³.

Subsequently, the SOI wafer of Example 2 was subjected to an extremely-short thermal treatment (laser annealing) which was performed in a process of manufacturing a device, in a laser spike annealing furnace in the condition of a maximum temperature of 1300°C. Then, whether there was slip dislocation migrated to the surface of the wafer or not was checked using an X-ray topography method. As a result, slip dislocation was not observed, as shown in Table 1.

### Example 3

A silicon wafer (oxygen concentration of 11.5×10¹⁷ to 13.6×10¹⁷ atoms/cm³ (Old-ASTM)) sliced from a monocrystaline silicon ingot of 200 nm in diameter, which is the same as that of Example 1, was heated to 650°C, and then oxygen ions with the acceleration energy of 200 keV and the dose amount of 5×10¹⁷/cm² were implanted into the silicon wafer.

Subsequently, similarly to Example 1, the monocrystaline silicon wafer was thermally treated at 1325°C for 8 hours in a mixed atmosphere of Ar and O₂, thereby producing an SOI wafer. The thickness of the active layer and the embedded SiO₂ layer formed by the above thermal treatment were checked using a transmission microscope. As a result, the thickness of the active layer was 200 nm, and the thickness of the embedded SiO₂ layer was 125 nm.

Furthermore, the SOI wafer was subjected to a thermal treatment at 1100°C in a mixed atmosphere of Ar and O₂, thereby performing a sacrificial oxidation. The oxide film produced by performing the sacrificial oxidation was stripped in a fluorinated acid solution. Then, the thickness of the active layer was checked using a transmission microscope. As a result, the thickness of the active layer was 100 nm.

The SOI wafer obtained in this way was subjected to a thermal treatment of pattern 3 shown in FIG. 3, and then defect density induced by the thermal treatment near the interface between the support layer and the insulated oxide film layer of the SOI wafer after the thermal treatment was evaluated by a 90° light-scattering method, using MO-441 (manufactured by Mitsui Mining & Smelting Co. Ltd.). As shown in Table 1, the light-scattering defect density was 1.8×10⁸/cm³.

Subsequently, the SOI wafer of Example 3 was subjected to a extremely-short thermal treatment (laser annealing) which was performed in a process of manufacturing a device, in a laser spike annealing furnace of a maximum temperature of 1300°C. Then, it was checked using an X-ray topography method whether there was slip dislocation migrated to the surface of the wafer or not. As a result, slip dislocation was not observed, as shown in Table 1.

### Example 4

A silicon wafer (oxygen concentration of 11.5×10¹⁷ to 13.6×10¹⁷ atoms/cm³ (Old-ASTM)) sliced from a monocrystaline silicon ingot of 200 nm in diameter, which is the same as that of Example 1, was thermally oxidized at 1100°C, thereby forming a oxide film of 300 nm. Then, hydrogen ions with the acceleration energy of 50 keV and the dose amount of 6×10¹⁷/cm² were implanted into the silicon wafer through the oxide film from the upper surface of the SOI wafer, thereby forming an ion-implanted layer in the wafer (the wafer used as an active layer).

Subsequently, the wafer used as the active layer was stuck with a silicon wafer (the wafer used as the support layer: oxygen concentration of 11.5×10¹⁷ to 13.6×10¹⁷ atoms/cm³ (Old-ASTM)) sliced from a monocrystaline silicon ingot of 200 nm in diameter, which is the same as that of Example 1, through the oxide film. Then, they were subjected to a thermally stripping treatment at 600°C, thereby stripping the wafer used as the active layer into a thin film by using the ion-implanted layer as the boundary. Furthermore, a thermal treatment was performed at 1100°C to strengthen the adhesion, thereby obtaining an SOI wafer in which these two wafers were rigidly bonded. Here, in order to remove the damage generated on the surface, sacrificial oxidization was performed in which the vicinity of the surface was oxidized by a thermal treatment in the oxygen atmosphere.

The thickness of the active layer and the embedded SiO₂ layer of the SOI wafer were checked using a transmission microscope. As a result, the thickness of the active layer was 100 nm, and the thickness of the embedded SiO₂ layer was 150 nm.

The SOI wafer obtained above was then subjected to a thermal treatment of pattern 4 shown in FIG. 4. The thermal treatment included the steps of: leaving the SOI wafer at 800°C for 4 hours; heating it to 950°C at a heating rate of 1.5°C/minute (100 minutes); heating it to 1000°C at a heating rate of 2°C/minute (25 minutes); and leaving it at 1000°C for 8 hours.

Similarly to Example 1, the defect density induced by the thermal treatment near the interface between the support layer and the insulated oxide film layer of the SOI wafer after the thermal treatment was evaluated by a 90° light-scattering method, using MO-441 (manufactured by Mitsui Mining & Smelting Co. Ltd.). As shown in Table 1, the light-scattering defect density was 1.7×10⁸/cm³.

Subsequently, the SOI wafer of Example 4 was subjected to an extremely-short thermal treatment (laser annealing) which was performed in a process of manufacturing a device, in a laser spike annealing furnace in the condition of a maximum temperature of 1300°C. Then, it was checked using an X-ray topography method whether there was slip dislocation migrated to the surface of the wafer or not. As a result, slip dislocation was not observed, as shown in Table 1.

### Comparative Example 1

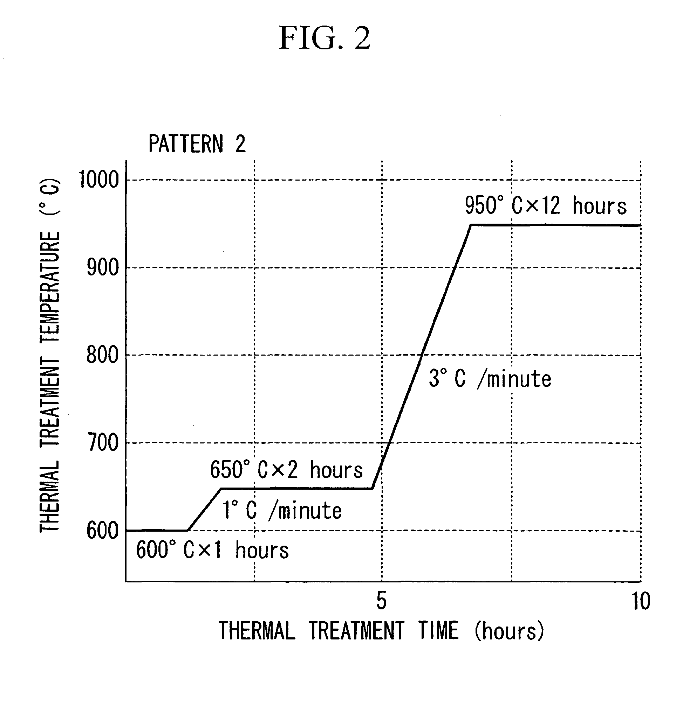

The SOI wafer (the thickness of the active layer was 200 nm, and the thickness of the embedded SiO₂ layer was 125 nm) obtained by the same condition as Example 1 was subjected to a thermal treatment of pattern 2 shown in FIG. 2. The thermal treatment included the steps of: leaving the SOI wafer at 600°C for 1 hour; heating it to 650°C at a heating rate of 1°C/minute (50 minutes); leaving it at 650°C for 2 hours; heating it to 950°C at a heating rate of 3°C/minute (100 minutes); and leaving it at 950°C for 12 hours.

Similarly to Example 1, the defect density induced by the thermal treatment near the interface between the support layer and the insulated oxide film layer of the SOI wafer after the thermal treatment was evaluated by a 90° light-scattering method, using MO-441 (manufactured by Mitsui Mining & Smelting Co. Ltd.). As shown in Table 1, the light-scattering defect density was 3.2× 10⁸/cm³.

Subsequently, the SOI wafer of Comparative Example 1 was subjected to an extremely-short thermal treatment (laser annealing) which was performed in a process of manufacturing a device, in a laser spike annealing furnace in the condition of a maximum temperature of 1200°C. Then, it was checked using an X-ray topography method whether there was slip dislocation migrated to the surface of the wafer or not. As a result, slip dislocation was observed, as shown in Table 1.

### Comparative Example 2

The SOI wafer (the thickness of the active layer was 100 nm, and the thickness of the embedded SiO₂ layer was 125 nm) obtained by the same condition as Example 3 was subjected to a thermal treatment of pattern 2 shown in FIG. 2.

Similarly to Example 1, the defect density induced by the thermal treatment near the interface between the support layer and the insulated oxide film layer of the SOI wafer after the thermal treatment was evaluated by 90° light-scattering method, using MO-441 (manufactured by Mitsui Mining & Smelting Co. Ltd.). As shown in Table 1, the light-scattering defect density was 3.5×10⁸/cm³.

Subsequently, the SOI wafer of Comparative Example 2 was subjected to an extremely-short thermal treatment (laser annealing) which was performed in a process of manufacturing a device, in a laser spike annealing furnace in the condition of a maximum temperature of 1200°C. Then, it was checked using an X-ray topography method whether there was slip dislocation migrated to the surface of the wafer or not. As a result, a large amount of slip dislocation was observed, as shown in Table 1.

### Comparative Example 3

The SOI wafer (the thickness of the active layer was 200 nm, and the thickness of the embedded SiO₂ layer was 125 nm) obtained by the same condition as Example 1 was subjected to a thermal treatment of pattern 2 shown in FIG. 2

Similarly to Example 1, the defect density induced by the thermal treatment near the interface between the support layer and the insulated oxide film layer of the SOI wafer after the thermal treatment was evaluated by a 90° light-scattering method, using MO-441 (manufactured by Mitsui Mining & Smelting Co. Ltd.). As shown in Table 1, the light-scattering defect density was 4.4×10⁸/cm³.

Subsequently, the SOI wafer of Comparative Example 3 was subjected to an extremely-short thermal treatment (laser annealing) which was performed in a process of manufacturing a device, in a laser spike annealing furnace in the condition of a maximum temperature of 1300°C. Then, it was checked using a X-ray topography method whether there was slip dislocation migrated to the surface of the wafer or not. As a result, a large amount of slip dislocation was observed, as shown in Table 1.

### Reference Example

A silicon wafer (oxygen concentration of 11.5×10¹⁷ to 13.6×10¹⁷ atoms/cm³ (Old-ASTM)) sliced from a monocrystaline silicon ingot of 200 nm in diameter, which is the same as that of Example 1, was thermally oxidized at 1100°C, thereby forming a silicon dioxide film of 200 nm.

Subsequently, the wafer obtained above (the wafer used as the active layer), which was covered with a silicon dioxide film of 200 nm, was stuck at room temperature with a silicon wafer (the wafer used as the support layer: oxygen concentration of 11.5×10¹⁷ to 13.6×10¹⁷ atoms/cm³ (Old-ASTM)) sliced from a monocrystaline silicon ingot of 200 nm in diameter, which is the same as that of Example 1 and not oxidized, thereby producing a laminated substrate (wafer). Then, they were subjected to thermally adhesive treatment at 1100°C to strengthen the adhesion.

Subsequently, grinding or etching was performed to the peripheral surface of the wafer used as the active layer, thereby removing defective parts of adhesion which lie on the peripheral surface of the laminated substrate.

Then, the wafer for the active layer was subjected to surface grinding or surface etching, thereby forming an active layer with the thickness of about 1000 nm. In this manner, a laminated SOI wafer was obtained.

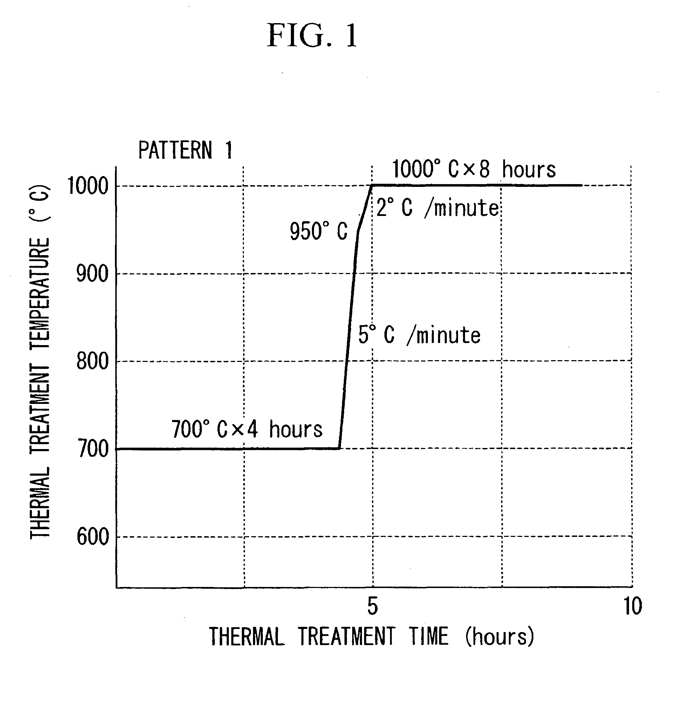

The SOI wafer (the thickness of the active layer was 1000 nm, and the thickness of the insulated oxide film layer was 200 nm) was subjected to a thermal treatment of pattern 1 shown in FIG. 1. The thermal treatment included the steps of: leaving the SOI wafer at 700°C for 4 hour; heating it to 950°C at a heating rate of 5°C/minute (50 minutes); heating it to 1000°C at a heating rate of 2°C/minute (25 minutes); and leaving it at 1000°C for 8 hours.

Similarly to Example 1, the defect density induced by the thermal treatment near the interface between the substrate layer and the insulated oxide film layer of the SOI wafer after the thermal treatment was evaluated by a 90° light-scattering method, using MO-441 (manufactured by Mitsui Mining & Smelting Co. Ltd.). As shown in Table 1, the light-scattering defect density was 3.2×10⁹/cm³.

Subsequently, the SOI wafer of Reference Example 1 was subjected to an extremely-short thermal treatment (laser annealing) which was performed in a process of manufacturing a device, in a laser spike annealing furnace in the condition of a maximum temperature of 1200°C. Then, it was checked using an X-ray topography method whether there was slip dislocation migrated to the surface of the wafer or not. As a result, slip dislocation was not observed, as shown in Table 1.

### Reference Example 2

A silicon wafer (oxygen concentration of 11.5×10¹⁷ to 13.6×10¹⁷ atoms/cm³ (Old-ASTM)) sliced from a monocrystaline silicon ingot of 200 nm in diameter, which is the same as that of Example 1, was thermally oxidized at 1100°C, thereby forming a silicon dioxide film of 200 nm.

Subsequently, the wafer (wafer used as the active layer) obtained above, which was covered with a silicon dioxide film of 200 nm was stuck with a silicon wafer (a wafer for a support: oxygen concentration of 11.5×10¹⁷ to 13.6×10¹⁷ atoms/cm³ (Old-ASTM)) sliced from a monocrystaline silicon ingot of 200 nm in diameter, which is the same as that of Example 1 and not oxidized, at room temperature, thereby producing a laminated substrate (wafer). Then, they were subjected to thermally adhesive treatment at 1100°C to strengthen the adhesion.

Subsequently, grinding or etching was performed to the peripheral surface of the wafer used as the active layer, thereby removing defective parts of adhesion which lie on the peripheral surface of the laminated substrate.

Then, the wafer used as the active layer was subjected to surface grinding or surface etching, thereby forming an active layer with the thickness of about 1000 nm. In this manner, a laminated SOI wafer was obtained.

The SOI wafer (the thickness of the active layer was 1000 nm, and the thickness of the insulated oxide film layer was 200 nm) obtained in this manner was subjected to a thermal treatment of pattern 1 shown in FIG. 1. Similarly to Example 1, the defect density induced by the thermal treatment near the interface between the support layer and the insulated oxide film layer of the SOI wafer after the thermal treatment was evaluated by a 90° light-scattering method, using MO-441 (manufactured by Mitsui Mining & Smelting Co. Ltd.). As shown in Table 1, the light-scattering defect density was 3.5×10⁹/cm³.

Subsequently, the SOI wafer of Reference Example 2 was subjected to an extremely-short thermal treatment (laser annealing) which was performed in a process of manufacturing a device, in a laser spike annealing furnace in the condition of a maximum temperature of 1300°C. Then, it was checked using an X-ray topography method whether there was slip dislocation migrated to the surface of the wafer or not. As a result, slip dislocation was not observed, as shown in Table 1.

| | Characteristics of a wafer | | | | Laser annealing | Result |
|---|---|---|---|---|---|---|
| | Method of manufacturing a SOI wafer | Thickness of an active layer (nm) | Level of a thermal treatment | light-scattering defect density at the depth of 260 µm from the interface (/cm³) | Maximum temperature (°C) | Slip disclocation |
| Example 1 | SIMOX | 200 | Level 3 | 1.1E+08 | 1200 | No |
| Example 2 | SIMOX | 200 | Level 3 | 1.9E+08 | 1300 | No |
| Example 3 | SIMOX | 100 | Level 3 | 1.8E+08 | 1300 | No |
| Example 4 | Adhesion (smart cut) | 100 | Level 4 | 1.7E+08 | 1300 | No |
| Comparative Example 1 | SIMOX | 200 | Level 2 | 3.2E+08 | 1200 | Yes |
| Comparative Example 2 | SIMOX | 100 | Level 2 | 3.5E+08 | 1200 | Extremely much amount |
| Comparative Example 3 | SIMOX | 200 | Level 2 | 4.4E+08 | 1300 | Much amount |
| Reference Example 1 | Adhesion (grinding) | 1000 | Level 1 | 3.2E+08 | 1200 | No |
| Reference Example 2 | Adhesion (grinding) | 1000 | Level 1 | 3.5E+08 | 1300 | No |

Reference Examples 1 and 2, the following is clarified. When an extremely-short annealing treatment is performed, it is thought that only the surface of a wafer is heated. Therefore, if the active layer has enough thickness, such as the cases of Reference Example 1 and 2, slip dislocation of the support layer is not generated, since the region heated in the wafer is restricted to the active layer. However, it is thought that, particularly if the active layer has the thickness of no more than 200 nm, a part of the insulated oxide film layer and the support layer is also heated. Therefore, the infrared radiation (IR) light scattering defect generates densely in the rapidly heated region. The defect obstacles to heat conduction, and high stress is generated near an interface between the support layer and the insulated oxide film layer, thereby generating slip dislocation.

### INDUSTRIAL APPLICABILITY

The SOI wafer of the present invention does not generate slip dislocation even if laser annealing is conducted at a maximum temperature of 1200°C or more for no more than 0.1 seconds, since the light-scattering defect density measured by a 90° light-scattering method at the depth region of 260 µm toward the support layer side from the interface between the insulated oxide film layer and the support layer is no more than 2×10⁸/cm³. Therefore, it is consequently extremely useful industrially.

## Claims

1. An SOI wafer used for a process, of manufacturing a semiconductor device, in which a laser annealing is conducted for no more than 0.1 seconds at a maximum temperature of 1200°C or more after completion of manufacturing of the SOI wafer, the SOI wafer comprising:
an active layer;
a support layer of a monocrystaline silicon; and
an insulated oxide film layer between the active layer and the support layer, wherein
light-scattering defect density measured by a 90° light-scattering method at the depth region of 260 µm toward the support layer side from an interface between the insulated oxide film layer and the support layer is 1.1x10⁸/cm³ to 1.9x10⁸/cm³,
the measurement of the light-scattering defect (light-scattering body) in the 90° light-scattering method is conducted by irradiating a light with a wavelength of 1.06 µm and the output power of 100 mW from the upper surface of the silicon wafer,
the 90° scattered light is detected from a cleavage surface of the wafer, and
the 90° scattered light is attenuated by passing through a filter.

2. An SOI wafer according to claim 1, wherein the thickness of the active layer is 200 nm or less.

3. A method of manufacturing an SOI wafer, comprising:
producing a SOI wafer having a insulated oxide film layer between a support layer of a monocrystalline silicon and an active layer;
subjecting the SOI wafer to a thermal treatment including the steps in the following order: leaving the SOI wafer at 600°C for 1 hour, heating the SOI wafer to 650°C at a heating rate of 1°C /minute (50 minutes), leaving the SOI wafer at 650°C for 2 hours, heating the SOI wafer to 950°C at a heating rate of 5°C /minute, and leaving the SOI wafer at 950°C for 12 hours.

4. A method of manufacturing an SOI wafer according to claim 3, wherein the thickness of the active layer is 200 nm or less.

## Patentansprüche

1. SOI-Wafer, der verwendet wird für ein Verfahren zur Herstellung einer Halbleitervorrichtung, bei dem ein Lasertempern für nicht mehr als 0,1 Sekunden bei einer maximalen Temperatur von 1200°C oder mehr nach der Beendigung der Herstellung des SOI-Wafers durchgeführt wird, wobei der SOI-Wafer umfasst:
eine aktive Schicht;
eine Trägerschicht aus einem monokristallinen Silicium; und
eine isolierte Oxidfilmschicht zwischen der aktiven Schicht und der Trägerschicht, wobei
die Lichtstreuungsdefektdichte, gemessen mit einer 90°-Lichtstreuungsmethode beim Tiefenbereich von 260 µm in Richtung der Seite der Trägerschicht von einer Grenzfläche zwischen der isolierten Oxidfilmschicht und der Trägerschicht, 1,1 x 10⁸/cm³ bis 1, 9 x 10⁸/cm³ ist,
die Messung des Lichtstreuungsdefekts (Lichtstreuungskörper) in der 90°-Lichtstreuungsmethode durchgeführt wird durch Bestrahlen mit einem Licht mit einer Wellenlänge von 1,06 µm und der Ausgangsleistung von 100 mW von der oberen Oberfläche des Siliciumwafers,
das 90°-gestreute Licht von einer Spaltoberfläche des Wafers detektiert wird und
das 90°-gestreute Licht abgeschwächt wird, indem es durch einen Filter geleitet wird.

2. SOI-Wafer gemäß Anspruch 1, wobei die Dicke der aktiven Schicht 20 nm oder weniger ist.

3. Verfahren zur Herstellung eines SOI Wafers, umfassend:
Herstellen eines SOI-Wafers, der eine isolierte Oxidfilmschicht zwischen einer Trägerschicht aus einem monokristallinem Silicium und einer aktiven Schicht hat;
Unterwerfen des SOI-Wafers einer thermischen Behandlung, einschließlich der Schritte in der folgenden Reihenfolge: Belassen des SOI-Wafers bei 600°C für 1 Stunde, Erhitzen des SOI-Wafers auf 650°C bei einer Heizrate von 100°C/Minute (50 Minuten), Belassen des SOI-Wafers bei 650°C für 2 Stunden, Erhitzen des SOI-Wafers auf 950°C bei einer Heizrate von 5°C/Minute und Belassen des SOI-Wafers bei 950°C für 12 Stunden.

4. Verfahren zur Herstellung eines SOI-Wafers gemäß Anspruch 3, wobei die Dicke der aktiven Schicht 20 nm oder weniger ist.

## Revendications

1. Tranche SOI utilisée pour un procédé de fabrication d'un dispositif à semi-conducteur, dans lequel un recuit au laser est réalisé pendant pas plus de 0,1 seconde à une température maximale de 1200 °C, ou plus, au terme de la fabrication de la tranche SOI, ladite tranche SOI comprenant :
une couche active ;
une couche support de silicium monocristallin ; et
une couche de film d'oxyde isolée entre la couche active et la couche support, dans laquelle
la densité des défauts de diffraction lumineuse, mesurée par une méthode de diffraction de la lumière à 90° dans la zone de profondeur de 260 µm en direction de la face de la couche support depuis une interface séparant la couche de film d'oxyde isolée et la couche support, est de 1,1 × 10⁸/cm³ à 1,9 × 10⁸/cm³,
la mesure du défaut de diffraction lumineuse (corps diffractant la lumière) dans la méthode de diffraction de la lumière à 90° est réalisée en irradiant une lumière à une longueur d'ondes de 1,06 µm et à la puissance d'émission de 100 mW depuis la surface supérieure de la tranche de silicium,
la lumière diffractée à 90° est détectée à partir d'une surface de clivage de la tranche, et
la lumière diffractée à 90° est atténuée en passant à travers un filtre.

2. Tranche SOI selon la revendication 1, dans laquelle l'épaisseur de la couche active est de 200 nm ou moins.

3. Procédé de fabrication d'une tranche SOI, consistant à :
produire une tranche SOI ayant une couche de film d'oxyde isolée entre une couche support de silicium monocristallin et une couche active ;
soumettre la tranche SOI à un traitement thermique incluant les étapes, dans l'ordre suivant, consistant à : laisser la tranche SOI à 600 °C pendant 1 heure, chauffer la tranche SOI à 650 °C à une vitesse de chauffage de 1 °C/minute (50 minutes), laisser la tranche SOI à 650 °C pendant 2 heures, chauffer la tranche SOI à 950 °C à une vitesse de chauffage de 5 °C/minute et laisser la tranche SOI à 950 °C pendant 12 heures.

4. Procédé de fabrication d'une tranche SOI selon la revendication 3, dans lequel l'épaisseur de la couche active est de 200 nm ou moins.
